# EUROPEAN PATENT SPECIFICATION

(11) **EP 2 360 661 B1**
(45) Date of publication and mention of the grant of the patent: **08.01.2014**
(21) Application number: 09827400.4
(22) Date of filing: 01.07.2009
(51) Int. Cl.: H05K 3/36, H05K 1/02, H05K 1/11, H05K 3/32, H01L 23/498, H01L 27/02, H01L 27/12

(54) **CIRCUIT SUBSTRATE, DISPLAY PANEL, AND DISPLAY DEVICE**
SCHALTKREISSUBSTRAT, ANZEIGETAFEL UND ANZEIGEVORRICHTUNG
SUBSTRAT DE CIRCUIT, PANNEAU D AFFICHAGE, ET DISPOSITIF D AFFICHAGE

(30) Priority: 19.11.2008 JP 2008296055
(43) Date of publication of application: 24.08.2011
(73) Proprietor: Sharp Kabushiki Kaisha, Osaka-shi, Osaka 545-8522 (JP)
(72) Inventor: MORIWAKI, Hiroyuki, Osaka-shi, Osaka 545-8522 (JP)
(74) Representative: Müller - Hoffmann & Partner
(86) International application number: PCT/JP2009/062060
(87) International publication number: WO 2010/058619

(56) References cited:
- JP-A- 10 282 522
- JP-A- 2000 221 540
- JP-A- 2002 258 768
- JP-A- 2003 007 749
- JP-A- 2003 098 975
- JP-A- 2003 131 253
- JP-A- 2005 309 303
- US-A1- 2005 072 597

## Description

### TECHNICAL FIELD

The present invention relates to a circuit substrate, a display panel and a display device. More specifically, the present invention relates to a circuit substrate suitable for narrowing the frame of a display device, and to a display panel and a display device provided with such a circuit substrate.

### BACKGROUND ART

The growth is continuously seen in the market of flat panel displays, such as liquid crystal displays (LCDs), plasma displays (PDPs), inorganic electroluminescent (inorganic EL) displays, and organic electroluminescent (organic EL) displays, which are being actively developed. This is associated with the progress of information technologies in recent years.

Electronic portable devices, such as mobile phones, PDAs and the like, to which such flat panel displays are fitted, are required to be ever smaller and lighter, which translates into a trend towards a smaller periphery (frame region) of the display region, i.e. into narrower frames.

In one configuration of conventional display devices, peripheral circuits required for driving circuits (driver circuits) and the like have been mounted at the frame region of a substrate that makes up the display panel. By contrast, display devices in which a full monolithic-type circuit substrate, where peripheral circuits are assembled into the frame region of the substrate, are set, have been developed in recent years with a view to, for instance, cutting costs and achieving thinner profiles.

Examples of conventional display devices include a display device provided with: common wirings that feed scanning line driving circuits that drive scanning lines, and common wirings that feed signal line driving circuits that drive signal lines; interlayer dielectrics that isolate respective common wirings; and a plurality of external connection terminals positioned on a plurality of respective contact holes that are provided in the interlayer dielectrics, in such a manner that part of each common wiring is exposed (for instance, Patent document 1). In such a display device, an anisotropic conductive film is disposed on the external connection terminals, such that connection to the exterior is elicited by way of the anisotropic conductive film.

Patent Document 1: Japanese Kokai Publication No. H10-282522

In the configuration of conventional display devices, the external connection terminals and the common wirings are connected by way of contact holes, and an external member such as a flexible printed circuit (FPC) board is bonded to the external connection terminals by way of the anisotropic conductive film that comprises conductive particles. In such a configuration, however, the conductive film that makes up the external connection terminals may become crushed by the conductive particles if the latter overlap the contact holes. This has been found to give rise to connection faults. As described above, configurations where common wirings and external connection terminals overlap make for a smaller frame area, as compared with configurations where the external connection terminals and the common wirings are disposed without overlapping each other. However, there remains still room for improvement in terms of achieving yet narrower frames.

US 2005/072597 A1 discloses a bonding pad structure of a display device. A first conductive layer is formed overlying a substrate, a protection layer is formed overlying the substrate and the first conductive layer, and a second conductive layer is formed overlying the protection layer. An opening structure penetrates the second conductive layer and the protection layer to expose the first conductive layer. A third conductive layer is formed overlying the second conductive layer to contact the sidewall and bottom of the opening structure. Thus, the third conductive layer is electrically connected to the second conductive layer to provide a first electrical-connection path, and the third conductive layer is electrically connected to the first conductive layer to provide a second electrical-connection path.

JP 2000 221540 A discloses that a dummy contact hole is disposed between adjacent terminals, thereby, the conductive particles of ACF are made to remain on the organic film to prevent the absence of the contact between the lower layer metal of the terminals and the connecting line of the TAB. The contact hole for connecting the upper layer transparent electrode of the terminals and the lower layer metal are composed of plural via holes, by which the conductive particles of the ACF on the upper layer transparent electrodes are sufficiently made to remain and the connecting with the connecting wires of the TAB is improved.

JP 2002 258768 A discloses that with respect to an electrooptical device where wiring is formed in an edge side area along the edge side of a substrate holding an electrooptical material and packaged parts like an IC chip are mounted in this edge side area, a protection layer covering the wiring and a connection terminal having a first part brought into contact with the wiring through an aperture part provided in the protection layer and a second part placed on the surface of the protection layer is provided. Conductive particles are interposed between the second part of the connection terminal and a terminal of the packaged parts to electrically connect the connection terminal and the terminal of packaged parts.

JP 10 282522 A discloses that an external connecting terminal group constituted of an external connecting terminal supplying a driving circuit with power source voltage and the external connecting terminal supplying the driving circuit with the power source voltage is arranged in an area at the outside of the driving circuit. The external connecting terminal of the center part of the external connecting terminal is connected to the driving circuit, and on the other hand, the external connecting terminals at both ends are connected to the driving circuit opposed with the display area between. Thus, a through-hole where parts of plural common wirings are respectively exposed is provided on the insulating film between the layers coated with the plural common wirings connected to a scanning line driving circuit or the like, and the common wiring and the external connecting terminal are respectively connected through the through-hole, so that the common wiring and the external connecting terminal are three-dimensionally arranged and the area of an insulated substrate is reduced.

### DISCLOSURE OF THE INVENTION

In the light of the above, it is an object of the present invention to provide a circuit substrate that affords a narrower frame in display devices or the like, while suppressing connection faults between wirings and external connection terminals.

The inventors conducted various studies on configurations of circuit substrates wherein an external connection terminal is connected to wiring by way of at least one contact hole, and wherein the circuit substrate is provided with an anisotropic conductive film that comprises conductive particles, on the external connection terminal, and focused on the relationship between contact holes and the anisotropic conductive film that is disposed on the external connection terminal. The inventors found that the conductive particles in the anisotropic conductive film may give rise to disconnection of the external connection terminal and to connection faults, among other problems, upon connection of an external member or the like to the external connection terminal. Further, the inventors found that connection faults between wiring and an external connection terminal can be prevented, without overlapping of the conductive particles with the entire region of the contact holes, by setting the length from one end to the other end, in a plan view, of a region, at which one or more contact holes connected to a specific external connection terminal is formed, to be greater than the diameter of each of the conductive particles. The inventors arrived at the present invention upon envisaging that the above finding could allow curbing drops in manufacturing yield due to connection faults or the like.

The above objects are solved by the claimed matter according to the independent claims 1 and 2.

The present invention is explained in detail next.

The circuit substrate of the present invention is a circuit substrate in which wiring, an insulating film and an external connection terminal are sequentially disposed on a substrate. Specifically, the circuit substrate of the present invention is a circuit substrate wherein wiring and an external connection terminal are disposed on a substrate, and an insulating film is disposed therebetween.

The wiring is ordinarily a member that affords current paths in the circuit substrate. Such wiring is not particularly limited, and in the case of wiring provided in a display device may include, for instance, power supply wiring for supply of power from outside, or signal wiring for transmitting a signal from outside or for transmitting a signal from the circuit substrate towards the exterior. In the case of a circuit substrate used in full-monolithic display devices, signal wiring is connected to, for instance, a driver circuit in the circuit substrate. If the driver circuit or the like is provided externally, the signal wiring may be provided in the form of, for instance, source wiring, gate wiring and storage capacitance wiring that transmit signals to pixels in order for the latter to carry out display.

The external connection terminal is a terminal used for transmitting external power and/or signals from the exterior (for instance, from an external member such as an FPC) to the wiring, or a terminal used for transmitting signals from the circuit substrate to the exterior. That is, the external connection terminal has electrical conductivity. The configuration of the external connection terminal is not particularly limited, and the external connection terminal may be, for instance, a single-layer film consisting of a single-layer conductive film, or a multilayer film comprising a stack of a plurality of conductive films.

The insulating film is a film formed of an insulating material for electrically isolating (insulating) between the wiring and the external connection terminal, at portions other than the portions at which the foregoing are connected by way of contact holes or the like. Examples of the material that can be used to form the insulating film include, but not limited thereto, for instance organic insulating materials, or inorganic insulating materials such as inorganic oxides, inorganic nitrides or the like. The insulating film may be one layer or a plurality of layers. In case that the insulating film comprises a plurality of layers, conductive layers may be interposed between respective insulating films, provided that the conductive layers are arranged in such a way so as not to connect electrically between the plurality of external connection terminals.

The circuit substrate is provided with an anisotropic conductive film comprising conductive particles, on the external connection terminals. The anisotropic conductive film is a film that has conductivity in an out-plane direction (normal direction with respect to the plane of the substrate) but lacks conductivity in an in-plane direction (direction within the plane of the substrate). As a result, the terminals of the external member and the external connection terminals of the circuit substrate can be electrically connected to each other in a one-to-one basis. Preferably, the anisotropic conductive film has adhesiveness, to elicit physical adhesion between the external connection terminals and the external member. Preferred examples of such an anisotropic conductive film include anisotropic conductive films that electrically connect the external connection terminals to the external member by way of conductive particles contained in an insulating material. The shape of the conductive particles is not particularly limited. The particles may be cubic, octahedral or the like, but preferably spherical.

The external connection terminal is connected to the wiring by way of at least one contact hole formed in the insulating film, such that the length from one end to the other end, in a plan view, of a region formed with one or more contact holes that connect to a specific external connection terminal is greater than the diameter of each of the conductive particles. In the circuit substrate of the present invention, thus, the external member and the external connection terminals are connected by way of an anisotropic conductive film, and the external connection terminals and wiring disposed directly below (at an region of overlap, in a plan view) the external connection terminals are connected by way of contact holes formed in the insulating film.

Two modes can be roughly distinguished herein, namely an mode (first mode) wherein one contact hole is provided for one external connection terminal, and an mode (second mode) wherein a plurality of contact holes is provided for one external connection terminal, as modes wherein the length, from one end to the other end, of a region at which there are formed one or more contact holes that connect to a specific external connection terminal is greater than the diameter of each of the conductive particles.

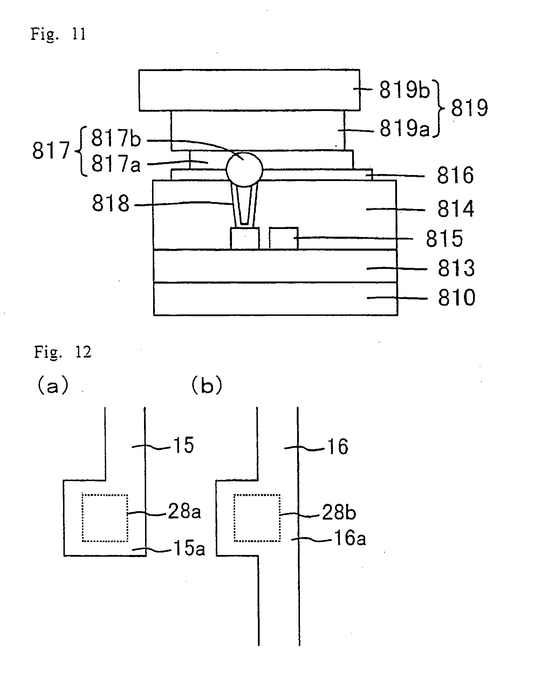

As in the circuit substrate illustrated in the cross-sectional schematic diagram of Fig. 11, in a case where one contact hole is formed in one external connection terminal, and the diameter of the contact hole is smaller than the diameter of each of the conductive particles, then a conductive particle 817b may end up breaking a conductive portion of a contact hole 818 that connects a wiring 815 and an external connection terminal 816 on a insulating film 814 formed at a region in which the contact hole 818 is not formed. This may give rise to a connection fault. One factor underlying the above occurrence is that the conductive layer on the contact hole wall surface is thinner than the conductive layer on the surface of the terminal. For instance, in case that a conductive particle in the anisotropic conductive film overlaps the contact hole upon thermocompression bonding of the external connection terminal and the external member by way of the anisotropic conductive film, then a connection fault may occur due to breakage of the contact hole wall surface and/or of the conductive layer (external connection terminal) in the vicinity of the contact hole.

In the first mode of the present invention, by contrast, the external connection terminal is connected to the wiring via only one contact hole. In a plan view, at least part of the contact hole has a greater diameter than the diameter of each of the conductive particles. Thus, in a case where one contact hole is provided in a specific external connection terminal, there need only be a portion such that the length, from one end to the other end, of the region at which the contact hole is formed, being herein the length of the diameter of the contact hole itself, is longer than the diameter of each of the conductive particles, at least in one direction. Specifically, the largest diameter of the contact hole need only be longer than the diameter of each of the conductive particles. For instance, the major-axis length of the contact hole (in square or perfectly circular contact holes, it can be considered that major axis is equal to minor axis) may be greater than the diameter of each of the conductive particles. Mode 1 (first mode) allows effectively suppressing disconnection between wiring and external connection terminals caused by contact hole breakage on account of pushing by conductive particles. The mode is effective for preventing connection faults.

In the present description, the diameter of conductive particles denotes the diameter of the conductive particles in case of spherical conductive particles, and denotes the largest diameter of the conductive particles when the latter are non-spherical, for instance ellipsoidal or the like. The diameter of the conductive particles can be measured, for instance, by optical microscopy. The conductive particle used for measurements may be, for instance, one arbitrarily selected particle from among a plurality of conductive particles that overlap the specific external connection terminal.

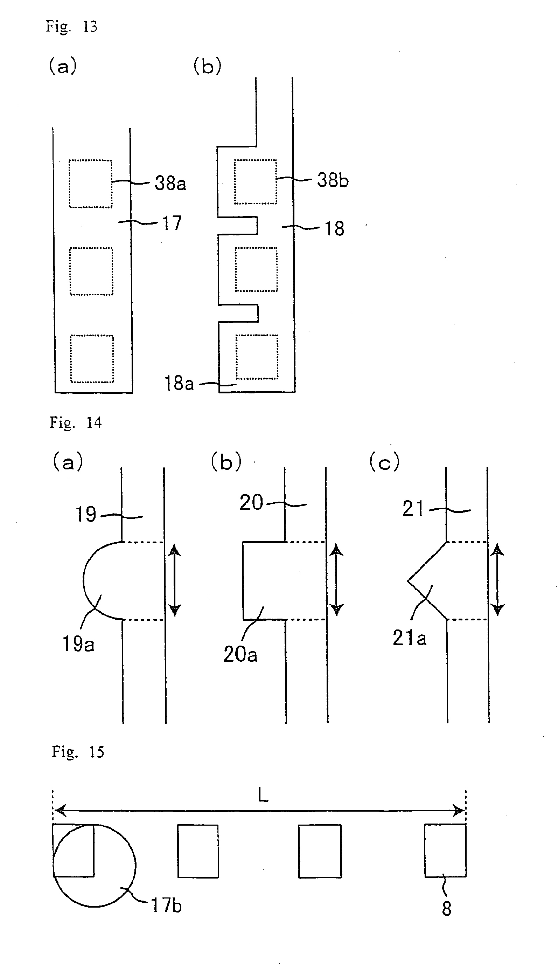

In the second mode of the present invention, the external connection terminal is connected to wiring by way of a plurality of contact holes, such that the length, from one end to the other end in a plan view, of a region at which the plurality of contact holes is formed is greater than a diameter of each of the conductive particles. Thus, in a case where a plurality of contact holes (one group of contact holes) is provided at one external connection terminal, the distance between one site at the outer edge of one contact hole up to a site at the outer edge of another contact hole (distance between outer edges of a group of contact holes) is greater than the diameter of each of conductive particles. As illustrated in Fig. 15, for instance, it is sufficient for the distance L from one end to the other end of a plurality of contact holes 8 to be greater than the diameter of a conductive particle 17b. In a mode wherein the wiring is connected to one external connection terminal by way of two or more contact holes, thus, connection between the external connection terminal and one of the contact holes is secured, even in case of a connection fault due to the other contact hole. Disconnection between the wiring and the external connection terminal can be prevented as a result.

In the second mode, the length from end to end of two or more contact holes connected to one external connection terminal, i.e. the greatest length from one arbitrary site at the outer edge of a contact hole provided in one external connection terminal, up to the other site (may be one site at the outer edge of the same contact hole, or one site at the outer edge of another contact hole), need only be greater than the diameter of each of the conductive particles. Especially, connection between wiring and external connection terminals can be secured in a particularly reliable manner in a mode wherein each contact hole has a diameter greater than the diameter of each of the conductive particles.

In the present invention, the greatest length, from one end to the other end, of the region at which there are formed one or more contact holes that connect to a specific external connection terminal is preferably 1.5 or more times as long as the diameter of each of the conductive particles, in terms of securing a margin for deformation that arises from pushing pressure, with a view to preventing connection faults more reliably.

In the present invention, the sizes of the contact holes provided in the substrate are dissimilar. For instance, the diameter of the contact holes may be different for each external connection terminal to which the contact hole is connected. In such a case, the anisotropic conductive film need only contain conductive particles having a diameter smaller than the length, from one end to the other end, of one contact hole or one group of contact holes formed to the smallest size from among a plurality of contact holes in the substrate (instance where one contact hole is formed in one external connection terminal) and a plurality of groups of contact holes (instance where a plurality of contact holes is formed in one external connection terminal).

The contact holes formed in the insulating film are ordinarily formed by dry etching, wet etching or the like. In a cross-sectional view of the contact hole, the length of the contact hole, from one end to the other end, may be dissimilar between the top face (face on the side of the external connection terminal) and the bottom face (face on the side of the substrate) of the insulating film, if the hole is formed to a tapered or reverse-tapered shape. In such a case, the length, from one end to the other end, of the region at which there are formed one or more contact holes that connect to a specific external connection terminal need only be greater than the diameter each of of the conductive particles at least at the top face of the insulating film. Breakage of the external connection terminal on account of the conductive particles can be fully prevented if the length, from one end to the other end, of the contact hole, at least at the top face of the insulating film, is greater than the diameter of each of the conductive particles.

The shape of the contact hole is not particularly limited, and may be polygonal, for instance, square, rectangular or triangular; or rounded, for instance perfectly circular, elliptical or the like. In a case where, for instance, the shape of the contact hole, in a plan view, is an elliptical shape, the reliability of the connections can be increased by preventing complete breakage of the conductive portion between the wiring and the external connection terminal, if the major axis of the ellipse is greater than the diameter of each of the conductive particles, even if the minor axis of the ellipse is smaller than the diameter of each of the conductive particles. That is, the contact hole may be an elongated hole, in a plan view, such that the largest diameter of the elongated hole is greater than the diameter of each of the conductive particles. To prevent connection faults more reliably, the largest diameter of the elongated hole is preferably 1.5 or more times as long as the diameter of each of the conductive particles. In a plan view, the shape of the elongated hole has a minor axis and a major axis, the shape being for instance an ellipse, a rectangular shape, an isosceles triangular shape or the like. As used herein, the term minor axis denotes the shortest diameter of the hole in a plan view, and the term major axis denotes the longest diameter of the hole in a plan view.

The area of the contact hole is not particularly limited, but is preferably greater than the area of conductive particles, in a plan view. A contact hole having a large area entails a greater contact area between the wiring and the external connection terminal. The resistance at the connection portion can be reduced as a result.

The external member connected to the anisotropic conductive film is not particularly limited, and may be, for instance, an electronic component such as a resistor, a capacitor, a coil, a connector, a diode, a transistor or the like; or a flexible printed circuit (FPC) board, a chip (COG: Chip on Glass) or resin film (COF: Chip on film) having formed thereon an integrated circuit (IC) that comprises circuit elements and wiring. Other examples include, for instance, a printed wiring board (PWB), a printed circuit board (PCB), a tape carrier package (TCP) or the like. Such external members are electrically connected to the external connection terminal by way of the anisotropic conductive film. Thus, the circuit substrate of the present invention comprises preferably an external member on an anisotropic conductive film. Preferably, the external member comprises a conductive protrusion at a region overlapping the external connection terminal. Such conductive protrusions are also referred to as "external connection wiring" or "bumps". The conductive protrusion is connected to the external connection terminal by way of the conductive particles in the anisotropic conductive film.

The configuration of the circuit substrate of the present invention is not particularly limited as regards the presence or absence of constituent elements other than the above-described essential constituent elements, namely the wirings, the insulating film, the external connection terminal, the anisotropic conductive film and the contact holes. For instance, the circuit substrate of the present invention may be appropriately used as a display device substrate employed in liquid crystal display devices or the like. When used as a display device substrate, the circuit substrate may be provided with, for instance, switching elements, such as thin film transistors (TFTs) for driving the pixels, as the smallest units that make up the display image, wiring such as source wiring and gate wiring that transmit signals to the pixels, as well as pixel electrodes for eliciting display.

In the case of a full monolithic-type circuit substrate provided with peripheral circuits required for driving, such as a driver circuit, the circuit substrate may be provided with circuits such as driver circuits, power supply circuits, electrostatic discharge (ESD) protective circuits or the like. Examples of driver circuits include, for instance, source driver circuits and gate driver circuits. Examples of circuits that make up a driver circuit include, for instance, transmission gates, latch circuits, timing generators, inverter circuits by a power source circuit or the like.

Preferred modes of the circuit substrate of the present invention are explained in detail below.

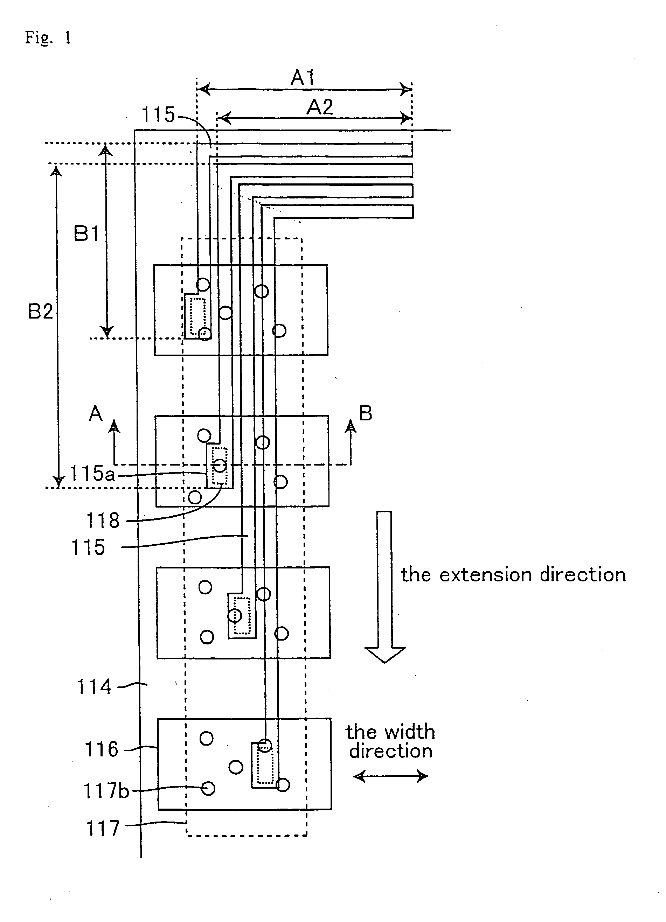

In a preferred mode of the circuit substrate of the present invention, the wiring has a wide portion that projects laterally with respect to the extension direction of the wiring, in a plan view, such that the contact hole is provided in the wide portion. Preferably, thus, the wiring has a wide portion that widens laterally with respect to the extension direction of the wiring, in a plan view; a contact hole is formed in the insulating film, on the wide portion; and the wiring and the external connection terminal are connected by way of the contact hole. The area of the contact hole formed in the insulating film can be increased thanks to the wide portion that projects with respect to the extension direction. This allows effectively preventing connection faults. The extension direction is the direction in which wiring extends linearly. In a state where a continuous stretch of wiring bends at a plurality of sites, the extension direction denotes the direction in which the wiring extends at the site where the wiring is connected to the external connection terminal; in other words, the direction pointing from the bent portion towards the external connection terminal. In a case where, for instance, wirings 115 and external connection terminals 116 are disposed as illustrated in Fig. 1, the extension direction is the direction denoted by the blanked arrow in Fig. 1. The lateral direction with respect to the extension direction is the width direction of the wiring, for instance the direction denoted by the double-headed arrow in the circuit substrate illustrated in Fig. 1.

In a preferred mode of the wide portion, the latter projects laterally towards only one side with respect to the wiring extension direction, in a plan view. The feature of projecting towards only one side with respect to the extension direction means that the width of the wiring increases (widens) towards either side in the width direction of the wiring. According to the preferred mode of the wide portion, the wiring width can be expanded only in a direction in which other wiring or the like is not disposed, and hence the length from one end to the other end of the contact hole increases, without widening of the distance between wirings. Connection faults between the wiring and the external connection terminal can be prevented thereby. In a case where, for instance, two or more wirings extend parallelly, the distance between the wirings can be reduced, while preventing contact between wirings, to a greater extent than in the case where the wide portion projects towards both sides in the width direction. This allows reducing, as a result, the wiring area. In current microfabrication techniques, the line width in the pads of contact holes is ordinarily greater than the wiring width. In a mode where the wide portion projects laterally towards both sides in the width direction, therefore, the distance between wirings is larger, and it becomes difficult to increase the number of wirings that are disposed under the external connection terminal.

The shape of the wide portion is not particularly limited, so long as it expands laterally with respect to the extension direction. The shape may be, for instance, that of a wide portion 19a in which wiring 19 widens in the form of a semicircle, as illustrated in Fig. 14(a), or the shape of a wide portion 20a in which wiring 20 widens in the form of a square, as illustrated in Fig. 14(b), or the shape of a wide portion 21a in which wiring 21 widens in the form of a triangle, as illustrated in Fig. 14(c). In the mode of Fig. 14(a), the mode of Fig. 14(b) and the mode of Fig. 14(c), the wide portion is referred to as a wiring portion within the area indicated by the double-headed arrow in the figure. A shape widened in the form of a square shape is suitable in terms of increasing the area of the wide portion. Upon actual formation of the wide portion, the corners thereof become ordinarily rounded, for reasons of patterning precision. Even with rounded corners, a square shape and a triangular shape may be regarded as such if the shape is substantially square or triangular. In a mode where wiring has the wide portion, the wide portion 15a may be formed at the leading end of the wiring 15, as illustrated in Fig. 12(a). Alternatively, the wide portion 16a may be formed halfway the wiring 16, as illustrated in Fig. 12(b).

In preferred modes where the wide portion projects laterally towards only one side with respect to the wiring extension direction, the circuit substrate has, in a plan view, two or more wirings extending parallelly, and two or more external connection terminals arrayed in the extension direction of the wirings; the two or more wirings have each a wide portion projecting towards an end portion side or an inward side of the circuit substrate, and a wiring disposed on the side toward which the wide portion projects is shorter, in the extension direction, than an adjacent wiring. Specifically: (1) the circuit substrate has, in a plan view, two or more wirings extending parallelly, and two or more external connection terminals arrayed in the extension direction of the wirings; the two or more wirings have each a wide portion projecting towards an end portion side of the circuit substrate, and a wiring disposed at the end portion side is shorter, in the extension direction, than an adjacent wiring (adjacent wiring disposed on an inward side); and (2) the circuit substrate has, in a plan view, two or more wirings extending parallelly, and two or more external connection terminals arrayed in the extension direction of the wirings; the two or more wirings have each a wide portion projecting towards the inward side of the circuit substrate, and a wiring disposed on an inward side is shorter, in the extension direction, than an adjacent wiring (adjacent wiring disposed on an end portion side).

In the above modes, the direction in which the wide portion projects is a direction towards either side, with respect to the wiring extension direction, and there is shortened the length, in the extension direction, of the wiring disposed on the side towards which the wide portion projects. Hence, the wide portion projects towards a side on which no wiring is disposed. Even if a wide portion is provided, therefore, the spacing between wirings that extend parallelly does not become shorter at the wide portion of one wiring and the another wiring adjacent to the wiring, and thus the wide portion can be provided while securing sufficient distance between wirings. This affords more integrated wiring. The area of the region at which the wiring is disposed can be reduced as a result. This affords a narrower frame in cases where the circuit substrate of the present invention is used as a display device substrate.

The length in the extension direction denotes herein the length in the direction of the external connection terminal, from a portion at which wiring bends, for instance as indicated by B1, B2 and so forth in the circuit substrate illustrated in Fig. 1. In the description of the present application, the term "parallel" applies not only to perfect parallelism, but also to instances of substantial parallelism, such as instances where the angle formed between wirings is no greater than 5°, in a case of two or more wirings that extend parallelly to each other. The end portion side of the circuit substrate denotes herein a side close to the end portion of the circuit substrate, from among both sides with respect to the wiring extension direction. The inward side of the circuit substrate denotes herein a side opposite to the side close to the end portion of the circuit substrate, from among both sides with respect to the wiring extension direction.

The arrangement mode of the two or more external connection terminals is not limited, so long as the two or more external connection terminals are arrayed in the direction in which the wirings extend. In a case where, for instance, a plurality of external connection terminals has an identical rectangular shape, then an external connection terminal whose short side is parallel to the wiring extension direction may be arranged alternately with an external connection terminal whose long side is parallel to the wiring extension direction. In a preferred mode, the external connection terminals whose short side is parallel to the wiring extension direction are arrayed along a row, with spacings in between, in terms of reducing the area of the region at which wiring is disposed and afford thus a narrower frame.

The above-described mode (1) is suitable for equalizing wiring resistance between wirings on the end portion side and wirings on the inward side, and is advantageous for increasing the operational stability of the circuit substrate. That is because, as in the circuit substrate illustrated in Fig. 1, when two or more parallel wirings bend at a corner of the substrate, a wiring on the end portion side is longer than a wiring on the inward side, and hence the length of the wiring on the end portion side, along the extension direction from the bent leading ends, is shorter than that of the wiring on the inwards side. The lengths of the wirings on the end portion side and on the inward side can be made similar to each other thereby.

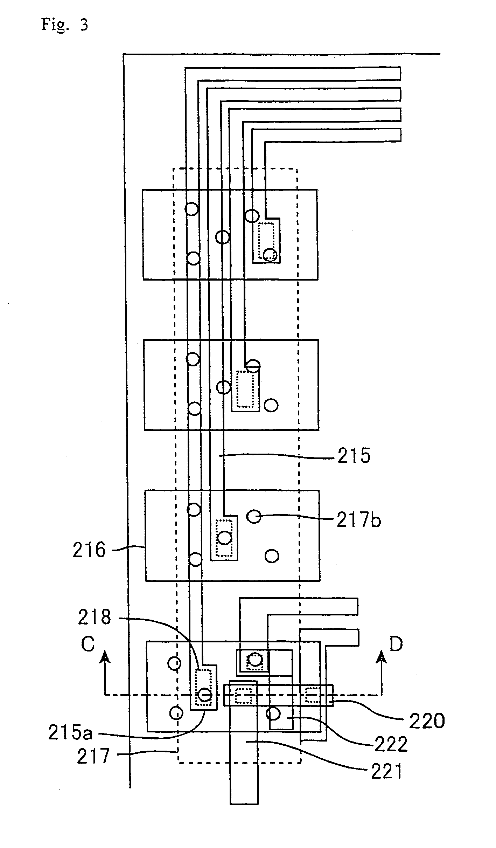

The above-described mode (2) is suitable for reducing the area of the region at which the wiring is disposed. This is advantageous for achieving a narrower frame, in cases where the circuit substrate of the present invention is used as a display device substrate. That is because making inward-side wirings shorter in the extension direction than wirings on the end portion side allows forming a region in which no wiring is disposed, and allows arranging elements such as circuit-forming wiring, a thin-film transistor or the like, at a region close to the inward side below the external connection terminal. In the circuit substrate illustrated in Fig. 3, for instance, wiring disposed on the end portion side of the circuit substrate is longer than wiring disposed on the inward side. Therefore, circuits such as transistors, as well as wiring connected thereto, are disposed below the external connection terminal, and there is reduced the area for forming the circuits or the like.

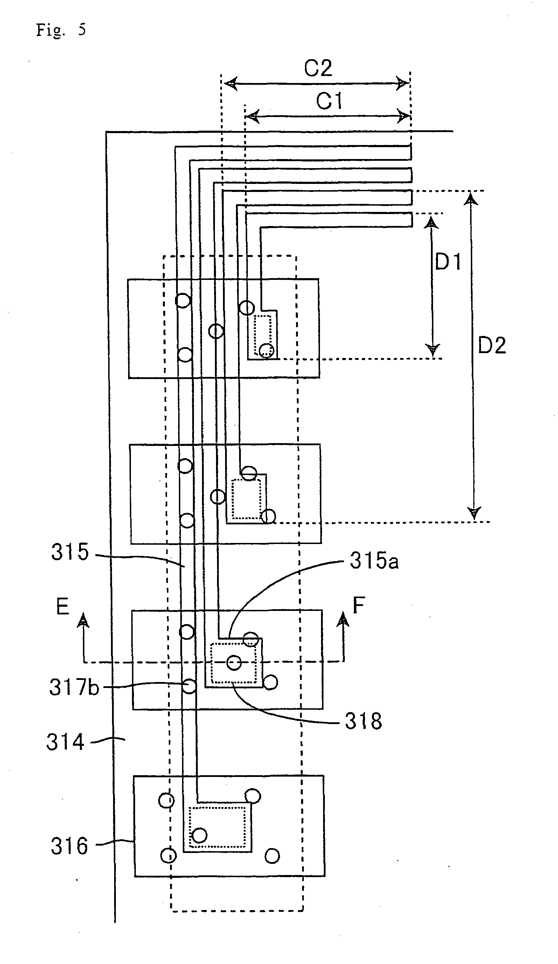

In the circuit substrate of the present invention, the two or more wirings are connected to the external connection terminal by way of contact holes having dissimilar area. The arrangement relationship between the wiring and the external connection terminal may be, for instance, the one illustrated in Fig. 5, wherein a wiring points towards the wiring extension direction, an adjacent wiring thereto is already connected to another external connection terminal, and no wiring is disposed at one of the wide portions of the wiring (on one side with respect to the extension direction). The area of the wide portion can be increased in such a case, and hence the area of the contact hole can be made accordingly greater. This allows adjusting the contact resistance between the external connection terminal and the wirings, which in turns allows compensating differences in wiring resistance due to differences in wiring length. Also, the occurrence of connection faults can be suppressed by increasing the area of the contact holes.

In the circuit substrate of the present invention, the two or more wirings are connected to contact holes such that the longer the wiring length, the greater the area of the contact hole is. For a given wiring width, the resistance of wiring increases as the wiring length increases. As a result, wiring resistance is smaller in shorter wiring, positioned inward of the circuit substrate, than in longer wiring, positioned on the end portion side of the circuit substrate, for instance in the case illustrated in Fig. 5. Therefore, wiring resistance can be made uniform, and the resistance of the contact hole portions can be adjusted, by increasing the area of the contact holes for wiring having a long wiring length, and decreasing the area of contact holes having a short wiring length. More uniform wiring resistance translates into enhanced operation stability of the circuit substrate. Herein, wiring length denotes the length of a continuous stretch of wiring that is joined to an element in a circuit. The continuous stretch of wiring may be made up of wirings formed in different layers but connected to each other.

The present invention is also a display panel provided with the above-described circuit substrate, and a display device provided with such a display panel. The present invention can be used in various types of display device, for instance in liquid crystal displays, plasma displays, inorganic electroluminescent displays, organic electroluminescent displays and the like.

In the display panel and display device of the present invention, the occurrence of connection faults between wiring and external connection terminals can be suppressed by setting the length, from one end to the other end, of a region at which there are formed one or more contact holes that connect to one external connection terminal, to be greater than the diameter of conductive particles, as described above. Manufacturing yields can be improved and productivity can be likewise enhanced as a result.

In addition suppression of connection faults, forming a wide portion in wiring allows also shortening the distance between wirings. This affords a narrower frame in the display device, and allows reducing the size and weight of the display device. The display device can therefore be suitable used in portable electronic devices such as mobile phones, PDAs and the like.

The circuit substrate of the present invention affords stable connection between wiring and external connection terminals, and allows suppressing the occurrence of connection faults.

### BRIEF DESCRIPTION OF THE DRAWINGS

Fig. 1 is a plan-view schematic diagram illustrating an end portion of a circuit substrate according to Example 1;
Fig. 2 is a cross-sectional schematic diagram illustrating an end portion of the circuit substrate according to Example 1;
Fig. 3 is a plan-view schematic diagram illustrating an end portion of a circuit substrate according to Example 2;
Fig. 4 is a cross-sectional schematic diagram illustrating an end portion of the circuit substrate according to Example 2;
Fig. 5 is a plan-view schematic diagram illustrating an end portion of a circuit substrate according to an Embodiment of the invention;
Fig. 6 is a cross-sectional schematic diagram illustrating an end portion of the circuit substrate according to the Embodiment;
Fig. 7 is a plan-view schematic diagram illustrating an end portion of a circuit substrate according to Example 4;
Fig. 8 is a plan-view schematic diagram illustrating an end portion of a circuit substrate according to Example 5;
Fig. 9 is a plan-view schematic diagram illustrating an end portion of a circuit substrate according to Example 6;
Fig. 10 is a plan-view schematic diagram illustrating an end portion of a circuit substrate according to Comparative Example 1;
Fig. 11 is a cross-sectional schematic diagram illustrating an end portion of the circuit substrate according to Comparative Example 1;
Fig. 12(a) is a plan-view schematic diagram illustrating an example where a wide portion is provided at the leading end of a wiring, and Fig. 12(b) is a plan-view schematic diagram illustrating an example where a wide portion is provided halfway along a wiring;
Fig. 13(a) is a plan-view schematic diagram illustrating a mode in which no wide portion is provided, in an instance where one wiring is connected at a plurality of contact holes, and Fig. 13(b) is a plan-view schematic diagram illustrating a mode in which a wide portion is provided for each contact hole, in an instance where one wiring is connected at a plurality of contact holes;
   Fig. 14(a) is a plan-view schematic diagram illustrating an example of a mode in which a wide portion projects, as a semicircular shape, from wiring, Fig. 14(b) is a plan-view schematic diagram illustrating an example of a mode in which a wide portion projects, as a quadrilateral shape, from wiring, and Fig. 14(c) is a plan-view schematic diagram illustrating an example of a mode in which a wide portion projects, as a triangular shape, from wiring; and
Fig. 15 is a plan-view schematic diagram illustrating a method for calculating the distance, from one end to the other end, of a region at which a contact hole is formed, in an instance where a plurality of contact holes is formed in one external connection terminal.

### EMBODIMENTS FOR CARRYING OUT THE INVENTION

The present invention will be explained in further detail below based on examples and embodiments, with reference to accompanying drawings. However, the present invention is not limited to these embodiments alone.

### (Example 1)

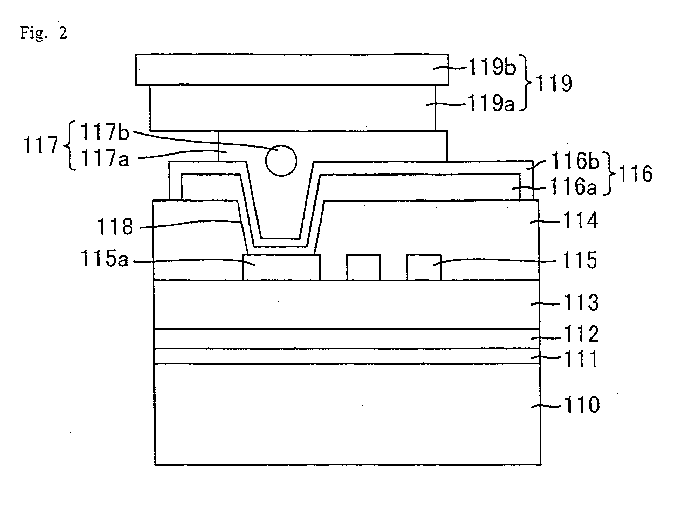

Fig. 1 is a plan-view schematic diagram illustrating an end portion of a circuit substrate according to Embodiment 1. Fig. 2 is a cross-sectional schematic diagram of the circuit substrate illustrated in Fig. 1 cut along line segment A-B. The circuit substrate according to Example 1 is a display device substrate used in liquid crystal display devices. Although not illustrated in Fig. 1 and Fig. 2, thin film transistors for pixel driving, as well as pixel electrodes, driver circuits and so forth are formed on the inward side of the circuit substrate.

As illustrated in Fig. 2, the end portion of the circuit substrate according to Example 1 has a substrate 110, and sequentially formed thereon, a base coat film 111, a first insulating film 112, a second insulating film 113, wirings 115, and a third insulating film 114. External connection terminals 116, being a stack of a metal film 116a and a transparent conductive film 116b, are disposed on the third insulating film 114. The film thickness of the third insulating film 114 is, for instance, 0.5 to 4 µm, and the film thickness of each external connection terminal is, for instance, 100 to 1000 nm. The external connection terminals 116 are connected to wide portions 115a of wiring by way of contact holes 118 formed in the third insulating film 114.

An anisotropic conductive film 117 is disposed on the external connection terminals 116, in order to electrically connect the external connection terminals 116 and external connection wirings 119a of a flexible printed circuit (FPC) board 119. The anisotropic conductive film 117 contains conductive particles 117b in an insulating material 117a. In the FPC 119, the external connection wirings 119a and so forth are provided on the surface of a resin substrate 119b.

. As illustrated in Fig. 1, the wirings 115 and the external connection terminals 116 of the circuit substrate according to Example 1 are connected by way of the contact holes 118 formed in the third insulating film 114, at the wide portions 115a of the wirings 115 that extend parallelly. The wirings 115 extend along the end portion of the substrate 110, and bend downwards, from the right direction in Fig. 1, in the vicinity of a corner of the substrate 110. In Fig. 1, a plurality of identically-shaped external connection terminals 116 are arrayed, spaced apart from each other, downwards from a corner of the substrate 110. Each wiring 115 extends downwards in Fig. 1 (wiring extension direction) along the end portion of the substrate 110, and is connected to a respective contact hole 118 at a wide portion 115a directly below a corresponding external connection terminal 116. The wide portions 115a are portions in which wiring is made wider, projecting towards the end portion of the substrate 110 (outwards), in order to for the contact holes 118 to be disposed therein. In the present example, the wide portions 115a are termini of the wirings 115. From among wirings 115 that extend parallelly, the further a wiring 115 is formed towards the end portion of the substrate 110, the further up in Fig. 1 the respective wide portion 115a is provided, i.e. the shorter becomes the length of the wiring having a bent leading end. The width of the wirings 115 is, for instance, 2 to 4 µm. The width of the wide portions 115a (lateral width with respect to the extension direction), is for instance 4 to 6 µm.

One contact hole 118 is provided in each external connection terminal 116. The contact holes 118 are shaped as a rectangle having a major-axis length (diameter length) of, for instance, 3 to 8 µm. The major-axis length of the contact holes denotes the length at the top face of the third insulating film 114.

The diameter of each of the conductive particles 117b is set to be smaller than the major-axis length of the contact hole, for instance from 2 to 6 µm. The value thereof is based on the diameter (largest diameter) after mounting of the FPC 119, in a plan view of the circuit substrate. The diameter of the conductive particles can be calculated by optical measurement methods using an optical microscope. The above considerations on the value of the diameter of the conductive particles apply also to other embodiments described below.

In the present example, the largest diameter of the contact holes 118 is greater than the diameter of the conductive particles 117b. As a result, the external connection terminals 116 and the external connection wirings 119a of the FPC 119 do not become electrically disconnected, even if the transparent conductive film 116b and the metal film 116a that make up the external connection terminals 116 are crushed by the conductive particles 117b. Connection reliability is thus excellent.

In the present example, the distance between wirings 115 can be shortened thanks to the wide portions 115a that are formed in the wirings 115 and that protrude only towards the end portion of the circuit substrate. This allows reducing, as a result, the area that must be secured within the plane the substrate in order to arrange the wirings 115, and enables frame narrowing.

Further, the wirings 115 disposed on the circuit substrate, on the end portion side, are connected to the external connection terminals 116 in such a manner that there decreases the length from the bent portion of the wirings. This allows the length of wirings disposed on the side of the end portion to be similar to the length of wirings disposed on the inward side, and allows uniformizing resistance between wirings 115. In Fig. 1, the length of wiring P disposed outermost on the end portion side of the circuit substrate equals A1+B1, and the length of adjacent wiring Q equals A2+B2. Herein, A1>A2 and B1<B2, and hence the wiring lengths in wiring P and wiring Q become similar, whereby resistance between both wirings can be made more uniform, as compared with a case in which wirings are connected, to external connection terminals, sequentially from wiring disposed on the inward side.

### (Example 2)

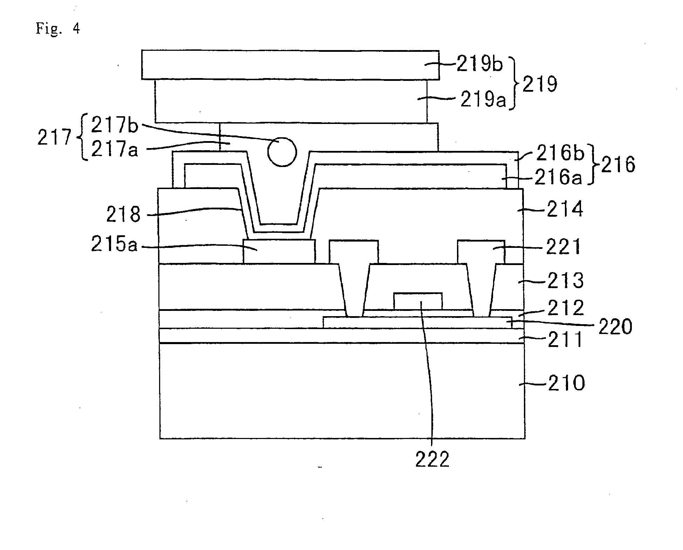

Fig. 3 is a plan-view schematic diagram illustrating an end portion of a circuit substrate according to Example 2. Fig. 4 is a cross-sectional schematic diagram of the circuit substrate illustrated in Fig. 3 cut along line segment C-D. The thickness of the wirings, insulating film and so forth in the circuit substrate according to Example 2 are identical to those in Example 1.

As illustrated in Fig. 4, the circuit substrate according to Embodiment 2 has a substrate 210, and sequentially stacked thereon, a base coat film 211, a semiconductor layer 220, a first insulating film (gate insulator) 212, gate wirings 222 and a second insulating film 213. Wirings 215 (Fig. 4 shows a wide portion 215a of the wirings 215) and source/drain wirings 221 are disposed on the second insulating film 213. The source/drain wirings 221 are connected to the semiconductor layer 220 by way of contact holes 218 formed in the second insulating film 213 and the first insulating film (gate insulator) 212. A third insulating film 214 is disposed on the wirings 215 and the source/drain wirings 221. External connection terminals 216, being a stack of a metal film 216a and a transparent conductive film 216b, are disposed on the third insulating film 214. The external connection terminals 216 are connected to wide portions 215a of the wirings 215 by way of the contact holes 218 formed in the third insulating film 214.

An anisotropic conductive film 217 is disposed on the external connection terminals 216, in order to electrically connect the external connection terminals 216 and external connection wirings 219a of the FPC 219. The anisotropic conductive film 217 contains conductive particles 217b in an insulating material 217a. In the FPC 219, the external connection wirings 219a and so forth are provided on the surface of a resin substrate 219b.

As illustrated in Fig. 3, the wirings 215 and the external connection terminals 216 of the circuit substrate according to Example 2 are connected by way of the contact holes 218 formed in the third insulating film 214, at the wide portions 215a of the wirings 215 that extend parallelly. The wirings 215 are connected to the external connection terminals 216 in such a manner that the length from the bent portion of the wiring is shorter the further the wiring is disposed inwards of the circuit substrate. The wirings 215 have a wide portions 215a that widen (project) towards the inward side of the circuit substrate. The width of the wirings 215 is for instance 2 to 4 µm, and the width of the wide portions 215a is for instance 4 to 6 µm.

The contact holes 218 are shaped as a rectangle having a major-axis length of, for instance, 3 to 8 µm, larger than the diameter of conductive particles. The major-axis length (diameter length) of the contact holes denotes the length at the top face of the third insulating film 214.

In Example 2, the connection position of the external connection terminals 116 to the wirings 115 shifts from the inwards side towards the end portion of the circuit substrate, as viewed from a corner of the circuit substrate, downwards in a longitudinal direction. An empty region is thus formed in the vicinity of the inward side of the circuit substrate, below the external connection terminal to which there is connected the wiring disposed on the end portion side of the circuit substrate. As a result, wirings that make up transistors, as well as a semiconductor layers and the like, can be formed below the external connection terminals 116, in addition to the wirings 115 that are connected to the external connection terminals 116. A narrower frame can be achieved thereby.

### (Embodiment)

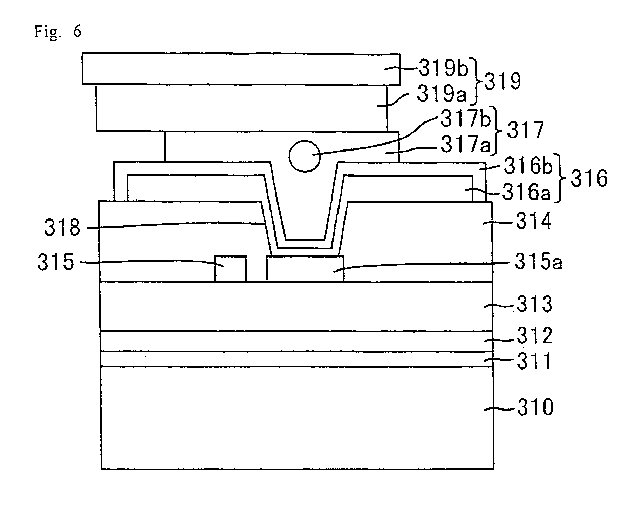

Fig. 5 is a plan-view schematic diagram illustrating an end portion of a circuit substrate according to an Embodiment of the invention. Fig. 6 is a cross-sectional schematic diagram of the circuit substrate illustrated in Fig. 5 cut along line segment E-F. The thickness of the wirings, insulating film and so forth in the circuit substrate according to the Embodiment are identical to those in Example 1. The circuit substrate according to the Embodiment is a display device substrate used in liquid crystal display devices. Although not illustrated in Fig. 5 and Fig. 6, thin film transistors for pixel driving, as well as pixel electrodes, driver circuits and so forth are formed on the inward side of the circuit substrate.

As shown in Fig. 6, at an end portion of the circuit substrate according to the Embodiment, a substrate 310 has sequentially stacked thereon a base coat film 311, a first insulating film (gate insulator) 312, a second insulating film 313, wirings 315 and a third insulating film 314. External connection terminals 316, being a stack of a metal film 316a and a transparent conductive film 316b, are disposed on the third insulating film 314. The external connection terminals 316 are connected to wide portions 315a of wiring by way of contact holes 318 formed in the third insulating film 314.

An anisotropic conductive film 317, for electrically connecting the external connection terminals 316 and external connection wirings 319a of an FPC 319, is disposed on the external connection terminal 316. The anisotropic conductive film 317 contains conductive particles 317b in an insulating material 317a. In the FPC 319, the external connection wirings 319a and so forth are provided on the surface of a resin substrate 319b.

In the circuit substrate according to the Embodiment, the wide portions 315a of the wirings 315 extending parallelly are connected to the external connection terminals 316 by way of respective contact holes 318 that are formed in the third insulating film 314, as illustrated in Fig. 5. The wirings 315 are connected to the external connection terminals 316 in such a manner that the length from the bent portion of the wiring is shorter the further the wiring is disposed inwards in the circuit substrate. Each wiring 315 has a wide portion 315a that widens (projects) towards the inward side of the circuit substrate. The width of the wirings 315 is, for instance, 2 to 4 µm. The width of the wide portions 315a is set in such a manner so as to become consecutively smaller for wirings disposed further inwards from the wiring that is disposed on the end portion side of the circuit substrate, and is set to, for instance, 4 to 6 µm.

The contact holes 318 are rectangular in shape, and the diameter length of the contact holes 318 is designed, like the width of the wide portions 315a, in such a manner so as to become consecutively smaller for contact holes disposed further inwards from the wiring that is disposed on the end portion side of the circuit substrate. The major-axis length of the contact holes 318 is larger than the diameter of the conductive particles 317b.

Thus, the longer the wirings 315 are, the larger becomes the area of the wide portions 315a and the contact holes 318. This allows uniformizing resistance between wirings 315. The greater the area of the contact holes 318 is, the lower becomes the resistance at the connection portions between the wirings 315 and the external connection terminals 316. As a result, the increased wiring resistance derived from the longer wiring length can be brought close to that of other shorter wiring. In a comparison between two wirings disposed inward in the circuit substrate in Fig. 5, the wiring length is C1+D1 for a wiring R disposed furthest inward within the area shown in the figure, the length of a wiring S disposed second is C2+D2, such that the length of wiring R disposed further inward is longer. As a result, the area of the contact holes 318 is greater for wirings disposed further outwards.

### (Example 4)

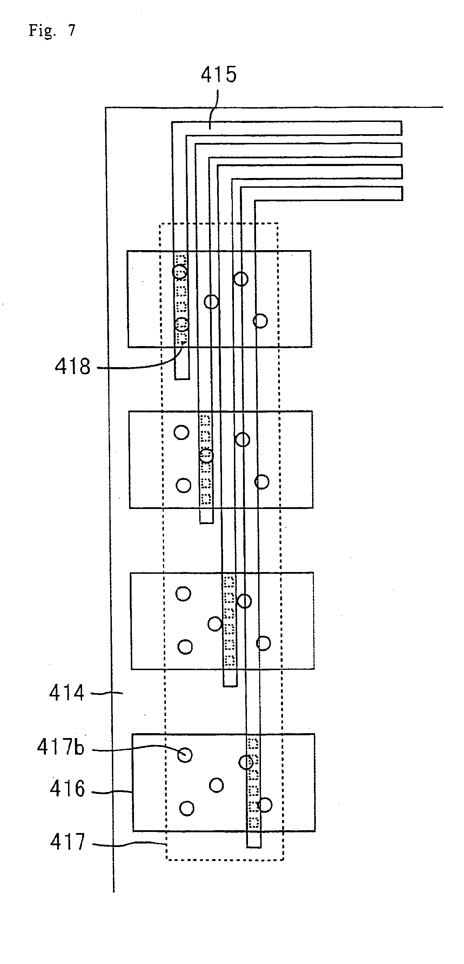

Fig. 7 is a plan-view schematic diagram illustrating an end portion of a circuit substrate according to Example 4. As illustrated in Fig. 7, the configuration of the circuit substrate according to Example 4 is substantially identical to that of Example 1, except that herein the area of the contact holes is different, and the wiring shape is different in that, for instance, no wide portions are provided.

In the circuit substrate according to Example 4, wirings 415 extending parallelly are connected to external connection terminals 416 by way of contact holes 418 that are formed in a third insulating film 414. The contact holes 418 are provided as a plurality thereof for each wiring, and are connected to each external connection terminal 416 at a plurality of sites. The width of the wirings 415 ranges from 3 to 5 µm.

The major-axis length of the contact holes 418 ranges from 2 to 4 µm, and the spacing between contact holes 418 ranges from 2 to 4 µm. Six contact holes 418 are formed in each wiring. Therefore, the length of the region at which the contact holes 418 are formed in one external connection terminal 416, from one end to the other end of the region, ranges from 22 µm (namely 6×2 µm+5×2 µm) to 44 µm (namely 6×4 µm+5×4 µm). The diameter of each of the conductive particles ranges from 2 to 6 µm. The plurality of contact holes 418 is formed on one wiring 415, and is connected to the external connection terminal 416 at a plurality of sites. Therefore, even if one of the contact holes 418 is crushed by the conductive particles 417b, the external connection terminal remains connected by way of other contact holes 418, and thus no connection faults occur. Although no wide portion is formed in the wiring of Example 4, a wide portion may be formed in regions corresponding to each contact hole, for instance as illustrated in Fig. 13(b).

### (Example 5)

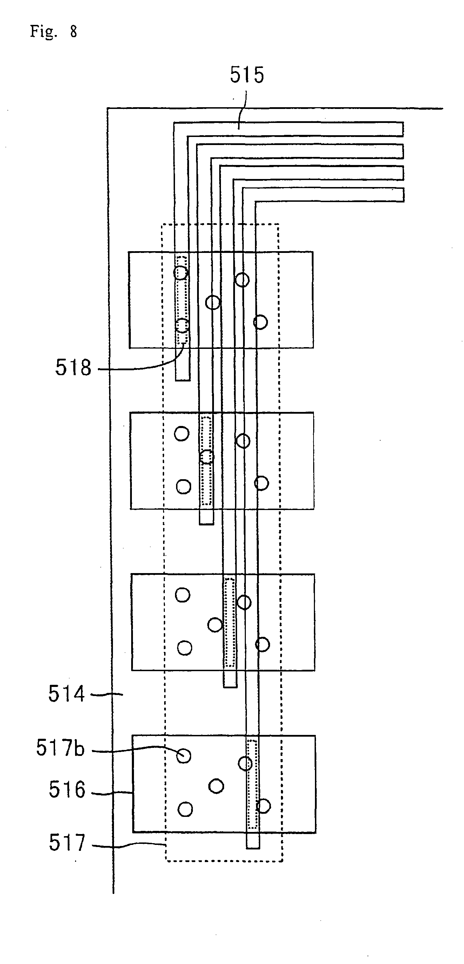

Fig. 8 is a plan-view schematic diagram illustrating an end portion of a circuit substrate according to Example 5. As illustrated in Fig. 8, the configuration of the circuit substrate according to Example 5 is substantially identical to that of Example 1, except that herein the area of the contact holes is different, and the wiring shape is different in that, for instance, no wide portions are provided. In the circuit substrate according to Example 5, wirings 515 extending parallelly are connected to external connection terminals 516 by way of contact holes 518 that are formed in a third insulating film 514. Herein, the contact holes 518 are shaped as elongated holes (rectangular-shaped) in the extension direction of the wirings 515. Such a shape allows preventing connection faults in that the entire connection portion is not destroyed even when part of the contact hole is crushed by conductive particles. The major diameter of the rectangular shape ranges from 3 to 20 µm, which is larger than the diameter of conductive particles. No wide portion is formed in the wiring of Example 5. In a more preferred embodiment, however, a wide portion is formed in the wirings 515, and the contact holes 518 are elongated holes.

### (Example 6)

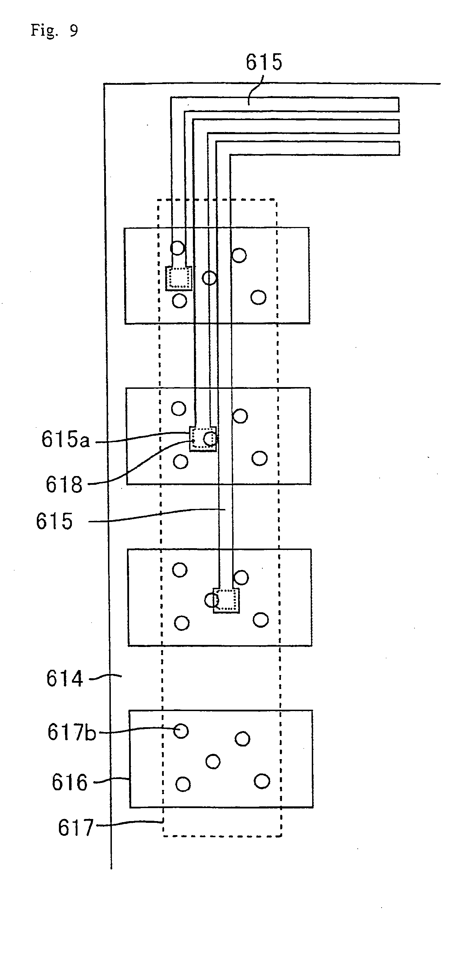

Fig. 9 is a plan-view schematic diagram illustrating an end portion of a circuit substrate according to Example 6. As illustrated in Fig. 9, the configuration of the circuit substrate according to Example 6 is substantially identical to that of Example 1, except that herein the area of the contact holes is different, and the wiring shape, such as the shape of the wide portions, is different, as illustrated in Fig. 9. In the circuit substrate according to Example 6, wirings 615 extending parallelly are connected to external connection terminals 616 by way of contact holes 618 that are formed in a third insulating film 614. Herein, the wirings 615 have wide portions 615a that protrude laterally towards both sides with respect to the direction in which the wirings extend (extension direction). The major-axis length of the contact holes 618 ranges from 4 to 9 µm. The diameter of each of the conductive particles 617b ranges from 3 to 6 µm. The major-axis length of the contact holes 618 is larger than the diameter of each of the conductive particles 617b. Disconnection due to the conductive particles 617b can be prevented thereby, since the major-axis length of the contact holes 618 is thus larger than the diameter of each of the conductive particles 617b. The width of the wirings 615 ranges from 2 to 4 µm, and the width of the wide portions 615a ranges from 3 to 6 µm.

In the configuration of Example 6, the wide portions are formed projecting laterally towards both sides with respect to the wiring extension direction. Therefore, the distance between wirings at the wide portions is smaller than in the configurations depicted in the Embodiment and Examples 1 to 5. As a result, the spacing between wirings may have to be kept not smaller than a given spacing, in order to prevent short-circuits between wirings at the wide portions, and the number of wirings that are disposed directly below the external connection terminals may be limited.

### (Comparative Example 1)

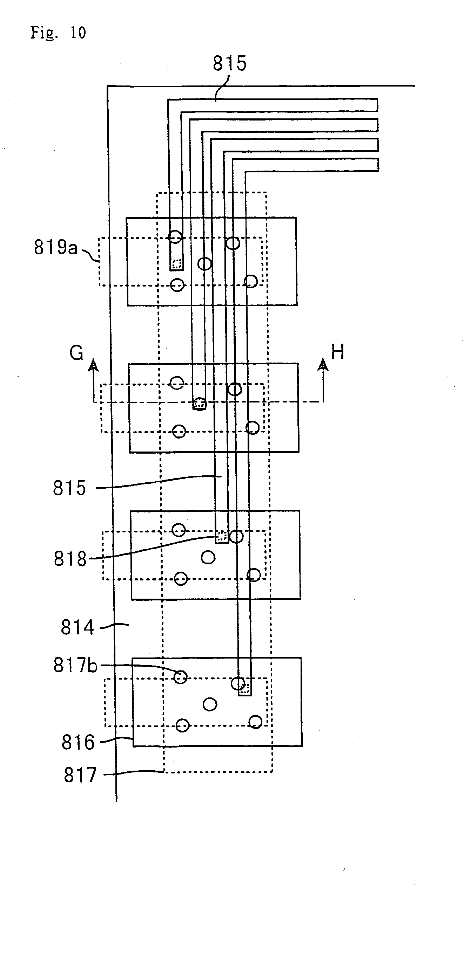

Fig. 10 is a plan-view schematic diagram illustrating an end portion of a circuit substrate according to Comparative Example 1. Fig. 11 is a cross-sectional schematic diagram of the circuit substrate illustrated in Fig. 10 cut along line segment G-H.

As illustrated in Fig. 11, a first insulating film 813 and wirings 815 are disposed on a substrate 810, at an end portion of the circuit substrate according to Comparative Example 1. A second insulating film 814 is disposed on the wirings 815, and external connection terminals 816 formed out of metal are disposed on the second insulating film 814. The external connection terminals 816 are connected to the wirings 815 by way of contact holes 818 formed in the third insulating film 814.

An anisotropic conductive film 817, for connection between the external connection terminals 816 and external connection wirings 819a of a flexible printed circuit (FPC) board 819, is disposed on the external connection terminals 816. The anisotropic conductive film 817 contains conductive particles 817b in an insulating material 817a. The external connection wirings 819a formed on the anisotropic conductive film 817 are electrically connected to the external connection terminals 816 by way of the anisotropic conductive film 817. In the FPC 819, the external connection wirings 819a and so forth are provided on the surface of a resin substrate 819b.

In the circuit substrate according to Comparative example 1, the leading ends of the wirings 815 extending parallelly are connected to the external connection terminals 816 by way of the contact holes 818 that are formed in the second insulating film 814, as illustrated in Fig. 10. In this case, the major-axis length of the contact holes 818 is 2 µm. The major-axis length of the contact holes 818 denotes the length at the top face of the second insulating film 814. The diameter of the conductive particles 817b is 5 µm. Thus, connection faults occur upon crushing by conductive particles 817b, since the major-axis length of the contact holes 818 is smaller than the diameter of the conductive particles 817b.

### Method for manufacturing the circuit substrates according to the Embodiment and Example 1, 2 and 4 to 6)

A method for manufacturing the circuit substrates according to the Embodiment and the examples is explained below. The manufacturing method will be explained based on an example of the circuit substrate according to Example 2 illustrated in Fig. 3 and 4, but the circuit substrates of the Embodiment and Examples 1 and 4 to 6 can also be manufactured in accordance with the same method, after suitable modification of, for instance, wiring shape and contact hole shape.

As a pre-treatment, the insulating substrate 210 is firstly subjected to cleaning and pre-annealing. The type of the insulating substrate 210 is not particularly limited, but is preferably, for instance, a glass substrate or resin substrate, from the viewpoint of costs, among others. Steps (1) to (10) below are carried out next.

### (1) Base coat film formation step

On the insulating substrate 210 there is formed the base coat film 211 through sequential formation of a SiON film and a SiOx film by plasma-enhanced chemical vapor deposition (PECVD). Examples of a starting material gas for forming the SiON film include, for instance, a mixed gas of monosilane (SiH₄), nitrous oxide gas (N₂O) and ammonia (NH₃). Preferably, the SiOx film is formed using tetraethyl ortho silicate (TEOS) gas as a starting material gas. As the base coat film 211 there may be used a silicon nitride (SiNx) film formed using, for instance, a mixed gas of monosilane (SiH₄) and ammonia (NH₃) as a starting material gas.

### (2) Semiconductor layer formation step

An amorphous silicon (a-Si) film is formed by PECVD. Examples of starting material gas for forming the a-Si film include, for instance, SiH4, disilane (Si₂H₆) and the like. The a-Si film formed by PECVD comprises hydrogen, and hence a treatment for lowering the hydrogen concentration in the a-Si layer is performed at about 500°C (dehydrogenation treatment). Laser annealing is performed next, followed by formation of a polysilicon (p-Si) film through melting of the a-Si film, cooling and solidification. Laser annealing is performed, for instance, using an excimer laser. In order to form continuous-grain (CG) silicon, a metallic catalyst may be applied, without performing a dehydrogenation treatment. A thermal treatment for solid-phase crystallization may be carried out, as a pre-treatment of laser annealing for forming the p-Si film. Next, dry etching is carried out using carbon tetrafluoride (CF₄) gas, to pattern the p-Si film and form the semiconductor layer 220. A source region, a drain region, a channel region and so forth are formed, for instance by ion doping, in the semiconductor layer 220 after the belowdescribed first insulating film formation step, or after a gate electrode formation step.

### (3) First insulating film (gate insulator) formation step

Next, the first insulating film (gate insulator) 212 comprising silicon oxide is formed using TEOS gas as a starting material gas. The material of the first insulating film 212 is not particularly limited, and there may be used, for instance, a SiNₓ film, a SiON film or the like. The starting material gas for forming the SiNₓ film and the SiON film may be the same as the starting material gas in the base coat film formation step described above. The first insulating film 212 may be a stack comprising the above-mentioned plurality of materials.

### (4) Gate electrode formation step

Next, a tantalum nitride (TaN) film and a tungsten (W) film are formed by sputtering. Next, a resist film is patterned to a desired shape, by photolithography, after which the gate electrode 222 is formed by dry etching using an etching gas in the form of a mixed gas in which there are adjusted the quantities of, for instance, argon (Ar), sulfur hexafluoride (SF₆), carbon tetrafluoride (CF₄), oxygen (O₂), chlorine (Cl₂) and the like. As the material of the gate electrode 222 there can be used a high-melting point metal having a planarized surface and stabilized characteristics and/or a low resistance metal , for instance tantalum (Ta), molybdenum (Mo), molybdenum tungsten (MoW) aluminum (Al) or the like. The gate electrode 222 may be a stack comprising the above-mentioned plurality of materials.

### (5) Second insulating film formation step

Next, a SiNx film, as the second insulating film 213, is formed on the entire surface of the substrate, by PECVD. A SiON film, TEOS film or the like may be used as the second insulating film 213. A thin cap film (for instance, a TEOS film) about 50 nm thick may be formed under the second insulating film 213 in order to stabilize electric characteristics and enhance reliability of TFT characteristics by preventing, for instance, transient degradation.

### (6) Contact hole formation step

Next, a resist film is patterned to a desired shape, by photolithography, after which the first insulating film 212 and the second insulating film 213 are wet-etched using a hydrofluoric acid-based etching solution, to form thereby a contact hole for connecting the source/drain wiring 221 and the semiconductor layer 220. Etching may be dry etching or a combination of wet etching and dry etching.

### (7) Wiring and source/drain wiring formation step

Next, a titanium (Ti) film, an aluminum (Al) film and a Ti film are formed, in this order, by sputtering or the like. Next, a resist film is patterned to a desired shape, by photolithography, after which the Ti/Al/Ti metal multilayer film is patterned by dry etching, to form the first source/drain wiring 221. Herein, the source region and drain region of the semiconductor layer 220 and the first source/drain wiring 221 are conductively connected by way of the contact hole formed in the first insulating film 212 and the second insulating film 213. An Al-Si alloy or the like may be used, instead of Al, as the metal that makes up the source/drain wiring 221. Herein, Al is used for lowering wiring resistance, but the above-described gate electrode materials (Ta, Mo, MoW, W, TaN or the like) may be used in a case of short wiring structures, where high heat resistance is required and a certain increase in resistance values is allowable.

### (8) Third insulating film formation step

Next, the third insulating film 214 comprising silicon oxide is formed on the entire surface of the substrate, using TEOS gas as a starting material gas. A SiON film, TEOS film or the like may be used as the third insulating film 214. An organic insulating film may also be used.

### (9) Contact hole formation step

Next, a resist film is formed on the entire surface of the substrate, and the resist film is patterned to a desired shape, by photolithography, after which the third insulating film 214 is wet-etched using a hydrofluoric acid-based etching solution, to form the contact hole 218 for connection between the external connection terminal 216 and the wiring 215. Etching may be dry etching. Also, development of the resist film and etching of the third insulating film 214 may be carried out simultaneously.

### (10) External connection terminal formation step

A metal film and an ITO film are formed, by sputtering or the like, on the third insulating film 214 having the contact hole 218 formed therein, and a desired shape is patterned by photolithography, to form thereby the transparent conductive film 216b and the metal film 216a that make up the external connection terminal 216. The metal film 216a is not particularly limited, but is preferably, for instance, a multilayer film of an aluminum film and a molybdenum film. Aluminum films have high conductivity, but are susceptible to electrochemical corrosion. Accordingly, corrosion of the aluminum film can be prevented by forming a molybdenum film, as a barrier film, on the aluminum film. Ordinarily, the aluminum film and the molybdenum film are patterned together simultaneously. Therefore, the end portion of the aluminum film is covered by forming thereon a transparent conductive film, of ITO or the like, in order to prevent corrosion of the end portion. Corrosion prevention can be afforded thereby. Preferably, the transparent conductive film 216b is formed in the same step as that of the pixel electrodes that drive the pixels of the display device. Doing so allows streamlining the manufacturing process. In Embodiments 1 to 6 described above, the external connection terminals are multilayer films of a metal film and a transparent conductive film, but are not particularly limited thereto, and may comprise a metal film alone.

Thereafter, the anisotropic conductive film 217 is affixed to the external connection terminal 216, and the FPC 219 having the external connection wirings 219a is affixed to the anisotropic conductive film 217.

To complete the liquid crystal display panel, a sealing material is formed on the circuit substrate, followed by affixing to an opposed substrate that has formed thereon, for instance, color filters and the like. The sealing material that is used is not particularly limited, and may be a UV-curable resin, a thermosetting resin or the like. Thereafter, a liquid crystal is sealed between the circuit substrate and the opposed substrate, to complete thereby the liquid crystal display panel. A liquid crystal display device can then be obtained by mounting polarizers and so forth on the liquid crystal display panel.

Connection faults between wiring and external connection terminals can be prevented in the liquid crystal display device thus formed. Also, a narrow-frame display device can be achieved by reducing the substrate area that is devoted to laying the wiring.

### EXPLANATION OF REFERENCE NUMERALS

15, 16, 17, 18, 19, 20, 21, 115, 215, 315, 415, 515, 615, 815: wiring
15a, 16a, 17a, 18a, 19a, 20a, 21a, 115a, 215a, 315a, 415a, 515a, 615a: wide portion
17b, 117b, 217b, 317b, 417b, 517b, 617b, 817b: conductive particles
8, 28a, 28b, 38a, 38b, 118, 218, 318, 818: contact hole
110, 210, 310, 410, 510, 610, 810: substrate
111, 211, 311: base coat film
112, 212, 312, 812: first insulating film
113, 213, 313, 814: second insulating film
114, 214, 314, 414, 514, 614: third insulating film
116, 216, 316, 416, 516, 616, 816: external connection terminal
116a, 216a, 316a: metal film
116b, 216b, 316b: transparent conductive film
117, 217, 317, 417, 517, 617, 817: anisotropic conductive film
117a, 217a, 317a, 417a, 517a, 617a, 817a: insulating material
119, 219, 319, 819: FPC
119a, 219a, 319a, 819a: external connection wiring
119b, 219b, 319b, 819b: resin substrate
220: semiconductor layer
221: source/drain wiring
222: gate electrode

## Claims

1. A circuit substrate having a substrate (310), on top of which, are disposed in order, wiring (315), an insulating film (314) and an external connection terminal (316), wherein
the circuit substrate is provided with an anisotropic conductive film (317) having conductive particles (317b) on the external connection terminal (316);
the external connection terminal (316) is connected to the wiring (315) via at least one contact hole (318) formed in the insulating film (314),
with the length from one end to the other end, in a plan view, of a region formed with one or more contact holes (318) that connect to a specific external connection terminal (316) being greater than the diameter of each of the conductive particles (317b);
**characterised in that**
the wiring (315) has a wide portion (315a) that projects laterally with respect to the extension direction of the wiring (315) in a plan view,
with the contact hole (318) being provided in the wide portion (315a);
the wide portion (315a) projects laterally towards only one side with respect to the extension direction of the wiring (315) in a plan view;
the circuit substrate has, in a plan view, two or more wirings (315) extending parallelly, and two or more external connection terminals (316) arrayed in the extension direction of the wirings (315);
the two or more wirings (315) have each a wide portion (315a) projecting towards an end portion side of the circuit substrate, and a wiring (315) disposed at the end portion side is shorter, in the extension direction, than an adjacent wiring (315);
the two or more wirings (315) are connected to the external connection terminal (316) by way of contact holes (318) having dissimilar area; and
the two or more wirings (315) are connected to contact holes (318) such that the longer the wiring length, the greater the area of the contact hole (318) is.

2. A circuit substrate having a substrate (310), on top of which, are disposed in order, wiring (315), an insulating film (314) and an external connection terminal (316), wherein
the circuit substrate is provided with an anisotropic conductive film (317) having conductive particles (317b) on the external connection terminal (316);
the external connection terminal (316) is connected to the wiring (315) via at least one contact hole (318) formed in the insulating film (314),
with the length from one end to the other end, in a plan view, of a region formed with one or more contact holes (318) that connect to a specific external connection terminal (316) being greater than the diameter of each of the conductive particles (317b);
**characterised in that**
the wiring (315) has a wide portion (315a) that projects laterally with respect to the extension direction of the wiring (315) in a plan view,
with the contact hole (318) being provided in the wide portion (315a);
the wide portion (315a) projects laterally towards only one side with respect to the extension direction of the wiring (315) in a plan view;
the circuit substrate has, in a plan view, two or more wirings (315) extending parallelly, and two or more external connection terminals (316) arrayed in the extension direction of the wirings (315);
the two or more wirings (315) have each a wide portion (315a) projecting towards the inward side of the circuit substrate, and a wiring (315) disposed on the inward side is shorter, in the extension direction, than an adjacent wiring (315);
the two or more wirings (315) are connected to the external connection terminal (316) by way of contact holes (318) having dissimilar area; and
the two or more wirings (315) are connected to contact holes (318) such that the longer the wiring length, the greater the area of the contact hole (318) is.

3. The circuit substrate according to claim 1 or 2, wherein
the external connection terminal (316) is connected to the wiring via only one contact hole (318), and
the contact hole (318) has, at least in part thereof in a plan view, a diameter that is longer than the diameter of each of the conductive particles (317b).

4. The circuit substrate according to claim 1 or 2, wherein
the external connection terminal (316) is connected to the wiring via a plurality of contact holes (318),
with the length from one end to the other end, in a plan view, of a region formed with the plurality of contact holes (318) being greater than a diameter of each of the conductive particles (317b).

5. A display panel, comprising the circuit substrate according to any one of claims 1 to 4.

6. A display device, comprising the display panel according to claim 5.

## Patentansprüche

1. Ein Schaltkreissubstrat mit einem Substrat (310), auf welchem der Reihe nach Verdrahtung (315), ein Isolierfilm (314) und ein externer Verbindungsanschluss (316) angeordnet sind, wobei
das Schaltkreissubstrat mit einem anisotropen leitfähigen Film (317) ausgestattet ist, welcher leitfähige Partikel (317b) auf dem externen Verbindungsanschluss (316) hat;
der externe Verbindungsanschluss (316) mit der Verdrahtung (315) über mindestens ein Kontaktloch (318) verbunden ist, welches in dem Isolierfilm (314) gebildet ist,
in Draufsicht, die Länge von einem Ende zum anderen Ende eines Bereichs, welcher mit einem oder mehreren Kontaktlöchern (318) gebildet ist, welche zu einem bestimmten externen Verbindungsanschluss (316) verbinden, größer ist als der Durchmesser von jedem der leitfähigen Partikel (317b); **dadurch gekennzeichnet, dass**
die Verdrahtung (315) einen breiten Teil (315a) hat, welcher in Draufsicht bezüglich der Erstreckungsrichtung der Verdrahtung (315) seitlich herausragt,
das Kontaktloch (318) in dem breiten Teil (315a) vorgesehen ist;
der breite Teil (315a) in Draufsicht seitlich in Richtung nur einer Seite bezüglich der Erstreckungsrichtung der Verdrahtung (315) herausragt;
das Schaltkreissubstrat in Draufsicht zwei oder mehrere Verdrahtungen (315) hat, welche sich parallel erstrecken, und zwei oder mehrere externe Verbindungsanschlüsse (316) hat, welche in der Erstreckungsrichtung der Verdrahtungen (315) angeordnet sind;
die zwei oder mehreren Verdrahtungen (315) jeweils einen breiten Teil (315a) haben, welcher in Richtung einer Endbereichsseite des Schaltkreissubstrats herausragt, und eine Verdrahtung (315), welche an der Endbereichsseite angeordnet ist, in der Erstreckungsrichtung kürzer ist als eine angrenzende Verdrahtung (315);
die zwei oder mehreren Verdrahtungen (315) mit dem externen Verbindungsanschluss (316) mittels Kontaktlöchern (318) verbunden sind, welche unterschiedliche Fläche haben; und
die zwei oder mehreren Verdrahtungen (315) mit den Kontaktlöchern (318) so verbunden sind, dass je länger die Verdrahtungslänge ist, umso größer die Fläche des Kontaktlochs (318) ist.

2. Ein Schaltkreissubstrat mit einem Substrat (310), auf welchem der Reihe nach Verdrahtung (315), ein Isolierfilm (314) und ein externer Verbindungsanschluss (316) angeordnet sind, wobei
das Schaltkreissubstrat mit einem anisotropen leitfähigen Film (317) ausgestattet ist, welcher leitfähige Partikel (317b) auf dem externen Verbindungsanschluss (316) hat;
der externe Verbindungsanschluss (316) mit der Verdrahtung (315) über mindestens ein Kontaktloch (318) verbunden ist, welches in dem Isolierfilm (314) gebildet ist,
in Draufsicht, die Länge von einem Ende zum anderen Ende eines Bereichs, welcher mit einem oder mehreren Kontaktlöchern (318) gebildet ist, welche zu einem bestimmten externen Verbindungsanschluss (316) verbinden, größer ist als der Durchmesser von jedem der leitfähigen Partikel (317b); **dadurch gekennzeichnet, dass**
die Verdrahtung (315) einen breiten Teil (315a) hat, welcher in Draufsicht bezüglich der Erstreckungsrichtung der Verdrahtung (315) seitlich herausragt,
das Kontaktloch (318) in dem breiten Teil (315a) vorgesehen ist;
der breite Teil (315a) in Draufsicht seitlich in Richtung nur einer Seite bezüglich der Erstreckungsrichtung der Verdrahtung (315) herausragt;
das Schaltkreissubstrat in Draufsicht zwei oder mehrere Verdrahtungen (315) hat, welche sich parallel erstrecken, und zwei oder mehrere externe Verbindungsanschlüsse (316) hat, welche in der Erstreckungsrichtung der Verdrahtungen (315) angeordnet sind;
die zwei oder mehreren Verdrahtungen (315) jeweils einen breiten Teil (315a) haben, welcher in Richtung der Innenseite des Schaltkreissubstrats herausragt, und eine Verdrahtung (315), welche an der Innenseite angeordnet ist, in der Erstreckungsrichtung kürzer ist als eine angrenzende Verdrahtung (315);
die zwei oder mehreren Verdrahtungen (315) mit dem externen Verbindungsanschluss (316) mittels Kontaktlöchern (318) verbunden sind, welche unterschiedliche Fläche haben; und
die zwei oder mehreren Verdrahtungen (315) mit den Kontaktlöchern (318) so verbunden sind, dass je länger die Verdrahtungslänge ist, umso größer die Fläche des Kontaktlochs (318) ist.

3. Das Schaltkreissubstrat gemäß Anspruch 1 oder 2, wobei
der externe Verbindungsanschluss (316) mit der Verdrahtung nur über ein Kontaktloch (318) verbunden ist, und
das Kontaktloch (318) in Draufsicht zumindest zum Teil einen Durchmesser hat, welcher länger ist als der Durchmesser von jedem der leitfähigen Partikel (317b).

4. Das Schaltkreissubstrat gemäß Anspruch 1 oder 2, wobei
der externe Verbindungsanschluss (316) mit der Verdrahtung über eine Mehrzahl an Kontaktlöchern (318) verbunden ist, und
in Draufsicht, die Länge von einem Ende zum anderen Ende eines Bereichs, welcher mit der Mehrzahl an Kontaktlöchern (318) gebildet ist, größer ist als ein Durchmesser von jedem der leitfähigen Partikel (317b).

5. Eine Anzeigetafel mit dem Schaltkreissubstrat gemäß einem der Ansprüche 1 bis 4.

6. Eine Anzeigevorrichtung mit der Anzeigetafel gemäß Anspruch 5.

## Revendications

1. Substrat de circuit comportant un substrat (310) sur lequel sont disposés, dans l'ordre, un câblage (315), un film isolant (314) et une borne de connexion externe (316), étant précisé
que le substrat de circuit est pourvu d'un film conducteur anisotrope (317) qui présente des particules conductrices (317b) sur la borne de connexion externe (316) ;
que la borne de connexion externe (316) est reliée au câblage (315) par l'intermédiaire d'au moins un trou de contact (318) formé dans le film isolant (314),
la longueur d'une extrémité à l'autre, vue en plan, d'une zone pourvue d'un ou plusieurs trous de contact (318) qui relient à une borne de connexion externe (316) spécifique étant plus grande que le diamètre de chacune des particules conductrices (317b) ;
**caractérisé en ce que** le câblage (315) a une partie large (315a) qui dépasse latéralement par rapport au sens d'extension du câblage (315), vu en plan,
le trou de contact (318) étant prévu dans la partie large (315a) ;
la partie large (315a) dépasse latéralement en direction d'un seul côté par rapport au sens d'extension du câblage (315), vu en plan ;
le substrat de circuit présente, vu en plan, deux câblages (315) ou plus qui s'étendent parallèlement, et deux bornes de connexion externe (316) ou plus qui sont alignées dans le sens d'extension des câblages (315) ;
les deux câblages (315) ou plus ont chacun une partie large (315a) qui dépasse en direction d'un côté de partie d'extrémité du substrat de circuit, et un câblage (315) disposé sur le côté de partie d'extrémité est plus court, dans le sens d'extension, qu'un câblage (315) voisin ;
les deux câblages (315) ou plus sont reliés à la borne de connexion externe (316) grâce à des trous de contact (318) qui présentent des surfaces inégales ; et
les deux câblages (315) ou plus sont reliés aux trous de contact (318) de telle sorte que plus la longueur de câblage est grande, plus la surface du trou de contact (318) est grande.

2. Substrat de circuit comportant un substrat (310) sur lequel sont disposés, dans l'ordre, un câblage (315), un film isolant (314) et une borne de connexion externe (316), étant précisé
que le substrat de circuit est pourvu d'un film conducteur anisotrope (317) qui présente des particules conductrices (317b) sur la borne de connexion externe (316) ;
que la borne de connexion externe (316) est reliée au câblage (315) par l'intermédiaire d'au moins trou de contact (318) formé dans le film isolant (314),
la longueur d'une extrémité à l'autre, vue en plan, d'une zone pourvue d'un ou plusieurs trous de contact (318) qui relient à une borne de connexion externe (316) spécifique étant plus grande que le diamètre de chacune des particules conductrices (317b) ;
**caractérisé en ce que** le câblage (315) a une partie large (315a) qui dépasse latéralement par rapport au sens d'extension du câblage (315), vu en plan,
le trou de contact (318) étant prévu dans la partie large (315a) ;
la partie large (315a) dépasse latéralement en direction d'un seul côté par rapport au sens d'extension du câblage (315), vu en plan ;
le substrat de circuit présente, vu en plan, deux câblages (315) ou plus qui s'étendent parallèlement, et deux bornes de connexion externe (316) ou plus qui sont alignées dans le sens d'extension des câblages (315) ;
les deux câblages (315) ou plus ont chacun une partie large (315a) qui dépasse en direction du côté intérieur du substrat de circuit, et un câblage (315) disposé sur le côté intérieur est plus court, dans le sens d'extension, qu'un câblage (315) voisin ;
les deux câblages (315) ou plus sont reliés à la borne de connexion externe (316) grâce à des trous de contact (318) qui présentent des surfaces inégales ; et
les deux câblages (315) ou plus sont reliés aux trous de contact (318) de telle sorte que plus la longueur de câblage est grande, plus la surface du trou de contact (318) est grande.

3. Substrat de circuit selon la revendication 1 ou 2, étant précisé que la borne de connexion externe (316) est reliée au câblage par l'intermédiaire d'un seul trou de contact (318),
que le trou de contact (318) présente, au moins dans une partie, vu en plan, un diamètre qui est plus grand que le diamètre de chacune des particules conductrices (317b).

4. Substrat de circuit selon la revendication 1 ou 2, étant précisé que la borne de connexion externe (316) est reliée au câblage par l'intermédiaire de plusieurs trous de contact (318),
la longueur d'une extrémité à l'autre, vue en plan, d'une zone pourvue des trous de contact (318) étant plus grande qu'un diamètre de chacune des particules conductrices (317b).

5. Panneau d'affichage comprenant le substrat de circuit selon l'une quelconque des revendications 1 à 4.

6. Dispositif d'affichage comprenant le panneau d'affichage selon la revendication 5.
